(19) Europäisches Patentamt
European Patent Office
Office européen des brevets

(11) **EP 4 738 013 A1**

(12) **EUROPEAN PATENT APPLICATION**

(43) Date of publication:
06.05.2026 Bulletin 2026/19

(21) Application number: 25204562.0

(22) Date of filing: 25.09.2025

(51) International Patent Classification (IPC):
*G03F 9/00* (2006.01)

(52) Cooperative Patent Classification (CPC):
G03F 9/7023; G03F 9/7026

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 01.10.2024 JP 2024172637

(71) Applicant: **Canon Kabushiki Kaisha**
**Tokyo, 146-8501 (JP)**

(72) Inventors:
• **SAITO, Yuki**
**Tokyo, 146-8501 (JP)**
• **MIURA, Seiya**
**Tokyo, 146-8501 (JP)**

(74) Representative: **TBK**
**Bavariaring 4-6**
**80336 München (DE)**

(54) **DETECTION APPARATUS, LITHOGRAPHY APPARATUS, AND ARTICLE MANUFACTURING METHOD**

(57)　A detection apparatus for detecting a surface position of a detection surface includes a mask with slits, a projection optical system configured to form an image on the detection surface by irradiating the detection surface with light having passed through the slits, an image sensor, and a light-receiving optical system configured to form, on the image sensor, an image of light reflected from the detection surface, wherein $\beta_1 = \tan\theta_2/\tan\theta_1$, 70° < $\theta_1$ < 85°, $\theta_2$ < 70°, and 0.03 < $\beta_1$ < 0.40 are satisfied, where $\theta_1$ represents an incident angle of the light to the detection surface, $\theta_2$ represents an incident angle of the light to the image sensor, and $\beta_1$ represents an optical magnification of the light-receiving optical system.

**F I G. 1**

EP 4 738 013 A1

**Description**

TECHNICAL FIELD

The present disclosure relates to a detection apparatus, a lithography apparatus, and an article manufacturing method.

BACKGROUND

Japanese Patent No. 3204406 discloses a surface position detection apparatus in which an object and a light-receiving optical system satisfy a Scheimpflug relationship and a diffraction grating for tilt correction is arranged on the image plane of the light-receiving optical system. Japanese Patent Laid-Open No. 10-004054 discloses a surface position detection apparatus in which an object and a light-receiving optical system satisfy a Scheimpflug relationship and a diffuser is arranged on the image plane of the light-receiving optical system. Japanese Patent No. 3271720 discloses a surface position detection apparatus in which an object and a light-receiving optical system satisfy a Scheimpflug relationship and a prism for tilt correction is arranged on the image plane of the light-receiving optical system.

SUMMARY

However, in the conventional surface position detection apparatuses, it is necessary to use, in the middle of the light-receiving optical system, a deflection optical element for changing an incident angle to an image sensor. In this case, it is necessary to provide an optical system that forms an image on the deflection optical element from a detection surface and an optical system that forms an image on the deflection optical element and the image sensor. Therefore, the cost for the optical systems increases, and the apparatus size also increases. In addition, the cost for the deflection optical element increases. A diffraction grating that increases diffracted light intensity to a specific angle is particularly expensive.

The present disclosure provides a technique advantageous in balancing surface position detection accuracy and cost.

The present disclosure in its first aspect provides a detection apparatus as specified in claims 1. Optional features are specified in claims 2 to 7.

The present disclosure in its second aspect provides a lithography apparatus as specified in claim 8.

The present disclosure in its third aspect provides an article manufacturing method as specified in claim 9.

Features of the present disclosure will become apparent from the following description of embodiments with reference to the attached drawings. The following description of embodiments is described by way of example.

BRIEF DESCRIPTION OF THE DRAWINGS

The accompanying drawings, which are incorporated in and constitute a part of the specification, illustrate embodiments of the present disclosure, and together with the description, serve to explain the principles of the embodiments.

Fig. 1 is a view showing the configuration of a surface position detection apparatus;
Fig. 2 is a graph showing the relationship between an incident angle and a surface reflectance;
Fig. 3 is a view showing the relationship of a Scheimpflug optical system;
Fig. 4 is a view showing the relationship of the Scheimpflug optical system in a projection optical system;
Fig. 5 is a view showing the relationship of the Scheimpflug optical system in a light-receiving optical system;
Fig. 6 is a graph exemplifying light receiving sensitivity to the incident angle to an image sensor;
Fig. 7 is a view showing an image of a projection pattern on a detection surface;
Fig. 8 is a graph showing the relationship among the optical magnification of an imaging optical system, the incident angle to the image sensor, and pixel sensitivity to a surface position variation;
Fig. 9 is a view showing an example of an image of a projection pattern on the image sensor;
Fig. 10 is a view showing the configuration of a surface position detection apparatus; and
Fig. 11 is a view showing the configuration of an exposure apparatus.

DESCRIPTION OF THE EMBODIMENTS

Hereinafter, embodiments will be described in detail with reference to the attached drawings. Note, the following embodiments are not intended to limit the scope of the claims. Multiple features are described in the embodiments, but it is not the case that all such features are required, and multiple such features may be combined as appropriate. Furthermore, in the attached drawings, the same reference numerals are given to the same or similar configurations, and redundant description thereof is omitted.

The present disclosure relates to a detection apparatus that detects the surface position of a detection surface. The detection apparatus according to the present disclosure can be applied to control (for example, focus control) of the surface position of a substrate in a lithography apparatus such as an exposure apparatus or an imprint apparatus, and can also be applied to other apparatuses such as a processing apparatus, an inspection apparatus, and a microscope.

<First Embodiment>

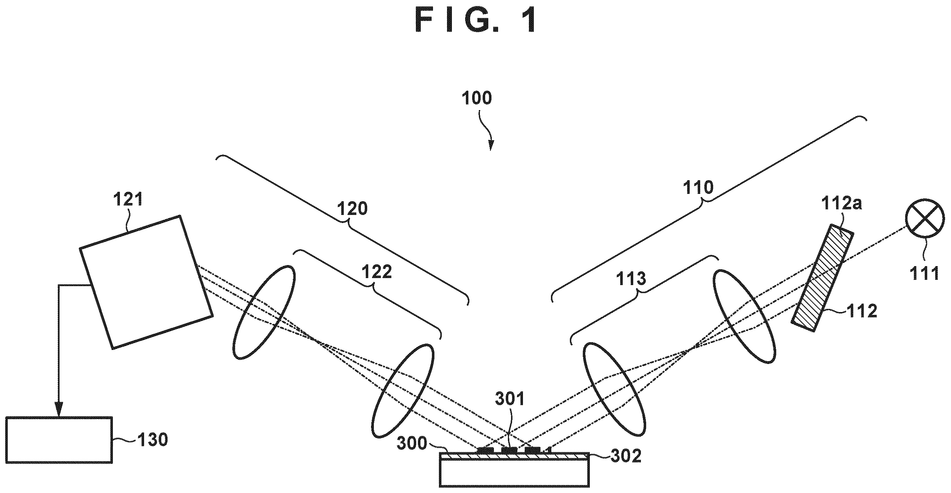

The configuration of a surface position detection apparatus 100 (detection apparatus) according to this embodiment will be described with reference to Fig. 1. The surface position detection apparatus 100 detects the surface position (the height of a detection target portion) of a detection surface 300. The surface position detection apparatus 100 can include a light projector 110, a light receiver 120, and a controller 130. The light projector 110 can include a light source 111, a mask 112 that includes a plurality of slits forming a projection pattern 112a, and a projection optical system 113 that projects the projection pattern 112a on the detection surface 300. Note that in accordance with the arrangement constraints of the light projector 110, the light projector 110 may include one or more intermediate imaging points in the middle of the projection optical system 113.

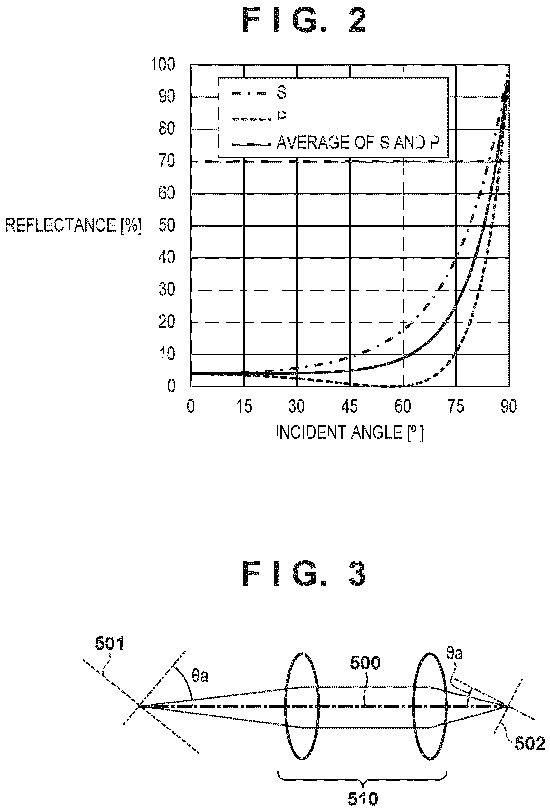

The projection optical system 113 is configured to form a pattern image on the detection surface 300 by performing irradiation with light having passed through the plurality of slits at a predetermined angle with respect to a normal to the detection surface 300, that is, from an oblique direction with respect to the detection surface 300. Especially in a semiconductor exposure apparatus, a resist 302 is applied onto the detection surface 300, and most of it transmits light. Fig. 2 shows a reflectance in a transparent layer having a refractive index n of 1.5. The average reflectance of S-polarized light and P-polarized light is 10% or less around an incident angle of 0° to 45°, and 90% or more of light is transmitted. If light is caused to enter at an angle larger than an angle (Brewster angle) at which the reflectance of P-polarized light is 0, the reflectance increases. To avoid the influence of a pattern under the resist 302, an incident angle at which the reflectance is high is desirably 70° or more.

The light receiver 120 can include an image sensor 121 that includes a plurality of pixels, and a light-receiving optical system 122 that forms, on the image sensor 121, an image of light reflected from the detection surface 300. Note that in accordance with the arrangement constraints of the light-receiving optical system 122 and the image sensor 121, the light receiver 120 may include one or more intermediate imaging points in the middle of the light-receiving optical system 122.

The controller 130 is formed by, for example, a computer including a CPU and a memory, and calculates the height of the detection surface 300 based on a detection result received by the image sensor 121. As an example of a height measurement method by the controller 130, there is a method of obtaining the height from a change, in a direction in which the light projector 110 projects a pattern to the detection surface 300, of a pattern image acquired via the image sensor 121. When the height of the detection surface 300 changes, the projection pattern projected onto the detection surface 300 changes depending on the projection direction on the detection surface 300 from the light projector 110. The controller 130 calculates the height of the detection surface 300 by measuring a change in position of the pattern image captured on the image sensor 121.

When the mask 112 and the detection surface 300 have a relationship satisfying a Scheimpflug condition with respect to the projection optical system 113, the entire surface of the projection pattern 112a is focused on the detection surface 300. This improves measurement accuracy. Furthermore, when measuring the height of the detection surface 300, it is possible to prevent a measurement value from changing due to a local tilt of the detection surface 300. Similarly, when the detection surface 300 and the image sensor 121 have a relationship satisfying a Scheimpflug condition with respect to the light-receiving optical system 122, the entire surface of the image sensor 121 is focused on the detection surface 300. This improves measurement accuracy.

In general, in a case where the relationship of the Scheimpflug optical system holds, the following equation is obtained. Referring to Fig. 3, when $\theta_a$ represents an angle formed by a normal to an object plane 501 and an optical axis 500 of an imaging optical system 510, $\theta_b$ represents an angle formed by a normal to an image plane 502 and the optical axis 500 of the imaging optical system 510, and $\beta$ represents the optical magnification of the imaging optical system 510, equation (1) below is obtained.

$$\beta = \tan\theta_b/\tan\theta_a \qquad \qquad \ldots(1)$$

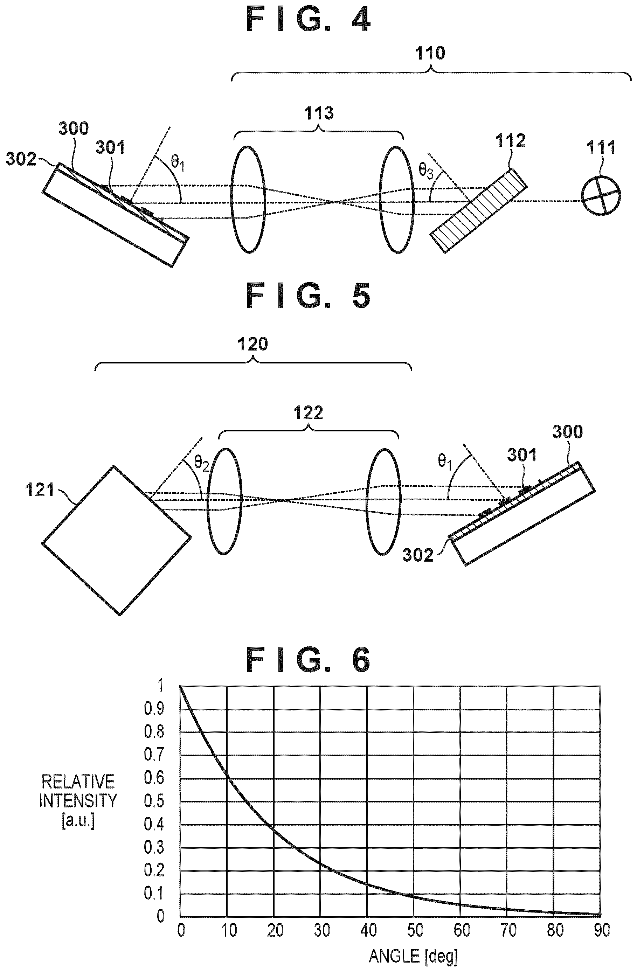

The relationship of the Scheimpflug optical system in the projection optical system 113 will be described with reference to Fig. 4. The incident angle, to the detection surface 300 (resist 302), of light irradiated by the projection optical system 113 is represented by $\theta_1$ (corresponding to $\theta_b$ in Fig. 3). An angle formed by the optical axis of the projection optical system 113 and a normal to the surface of the mask 112 is represented by $\theta_3$ (corresponding to $\theta_a$ in Fig. 3). The optical magnification of the projection optical system 113 is represented by $\beta_2$. In this case, the optical magnification $\beta_2$ of the projection optical system 113 is given by:

$$\beta_2 = \tan\theta_1/\tan\theta_3 \qquad \qquad ...(2)$$

When equation (2) is satisfied, the mask 112 and the detection surface 300 have a relationship satisfying the Scheimpflug condition with respect to the projection optical system 113.

When $\theta_1 = 70°$ and the optical magnification $\beta_2$ of the projection optical system 113 is 2, the angle $\theta_3$ formed by the optical axis of the projection optical system 113 and the normal to the surface of the mask 112 is 54° in accordance with equation (2).

Similarly, the relationship of the Scheimpflug optical system in the light-receiving optical system 122 will be described with reference to Fig. 5. The incident angle, to the detection surface 300 (resist 302), of light irradiated by the projection optical system 113 is represented by $\theta_1$. The incident angle, to the image sensor 121, of light irradiated by the light-receiving optical system 122 is represented by $\theta_2$ (corresponding to $\theta_a$ in Fig. 3). The optical magnification of the light-receiving optical system 122 is represented by $\beta_1$. In this case, the optical magnification $\beta_1$ of the light-receiving optical system 122 is given by:

$$\beta_1 = \tan\theta_2/\tan\theta_1 \qquad \qquad ...(3)$$

When equation (3) is satisfied, the detection surface 300 and the image sensor 121 have a relationship satisfying the Scheimpflug condition with respect to the light-receiving optical system 122.

Assume here that the incident angle $\theta_1$ (corresponding to $\theta_a$ in Fig. 3) to the detection surface 300 (resist 302) is 70° and the optical magnification $\beta_1$ of the light-receiving optical system 122 is 1 (that is, equal-magnification imaging). In this case, in accordance with equation (3), the incident angle $\theta_2$ ($\theta_b$) to the image sensor 121 is 70°. In the case of a large incident angle, a light beam may not reach a photoelectric conversion plane due to the surface reflection on the protective surface of the image sensor 121 and the internal wiring layer of the image sensor 121, and thus effective light energy may not reach a pixel.

To cope with this, in the surface position detection apparatus 100 of this embodiment, the optical magnification $\beta_1$ of the light-receiving optical system 122 is set smaller than 1 in consideration of equation (3). Thus, when $\theta_1$ is fixed, the incident angle $\theta_2$ to the image sensor 121 can be made small. In Fig. 5, as an example, when $\theta_1 = 80°$ and the optical magnification $\beta_1$ of the light-receiving optical system 122 is 0.2, $\theta_2 = 49°$ is obtained. By using the image sensor 121 having sensitivity to $\theta_2 = 49°$, it is possible to arrange the image sensor 121 on the image plane of the light-receiving optical system 122 and perform measurement.

Note that if intermediate imaging is provided in the middle of light-receiving optical system 122, even if the optical magnification of a part of the light-receiving optical system 122 is larger than 1, the optical magnification from the detection surface 300 to the image sensor 121 need only be smaller than 1.

As the image sensor 121, there are a Front-Side Illumination (FSI) image sensor including a multilayer wiring between the surface of the image sensor and the light-receiving surface and a Back-Side Illumination (BSI) image sensor including a light-receiving surface between the surface of the image sensor and a multilayer wiring. In general, since the BSI image sensor includes no multilayer wiring between the surface of the image sensor and the light-receiving surface, it has sensitivity to a large incident angle. In a case where light is caused to enter the image sensor 121 at a large incident angle as in this embodiment, the BSI image sensor is desirably used.

Fig. 6 shows an example of light receiving sensitivity to the incident angle to the image sensor. Referring to Fig. 6, in general, as the incident angle to the image sensor increases from 0°, the light receiving sensitivity of the image sensor decreases. The causes for this are a decrease in transmittance caused by the cover glass on the surface of the image sensor and the incidence of a light beam in the wiring layer of the image sensor. When the incident angle is smaller than 70° ($\theta_2 < 70°$), effective light receiving sensitivity for use is obtained. The incident angle $\theta_2$ is preferably set equal to or smaller than an angle at which the light receiving sensitivity of the image sensor used is obtained. Thus, an optical element that deflects the incident angle $\theta_2$ at an angle at which the light receiving sensitivity of the image sensor is obtained is unnecessary.

In accordance with the measurement accuracy of the surface position detection apparatus 100, the optical magnification $\beta_1$ of the light-receiving optical system 122 is preferably made closer to 1 within a range of less than 1. When ds represents an image position change amount on the image sensor 121 in a case where the surface position changes by dz, pixel sensitivity dz/ds is given by:

$$\frac{dz}{ds} = \frac{1}{2\beta \tan \theta_1} \sqrt{\frac{1 + \tan^2 \theta_1}{1 + \beta^2 \tan^2 \theta_1}} \qquad (4)$$

When $\theta_1$ is fixed, if the optical magnification $\beta_1$ of the light-receiving optical system 122 is increased, pixel sensitivity decreases, thereby improving measurement accuracy. When, for example, $\theta_1 = 85°$, $\beta_1 = 0.2$, and the pixel size of the image sensor 121 is 2.0 $\mu$m/pixel, pixel sensitivity to a surface position variation is 2.0 $\mu$m/pixel. To the contrary, if $\beta_1 = 0.5$ is set and is made closer to 1 within a range of less 1, pixel sensitivity is 0.34 $\mu$m/pixel, and measurement accuracy is improved by 5.8 times. Based on necessary measurement accuracy, the pixel sensitivity of the image sensor 121 to the surface position variation of the detection surface 300 is preferably 0.1 $\mu$m/pixel or more. When the optical magnification is made closer to 1 within a range in which effective light energy is obtained with respect to the light receiving sensitivity of the image sensor 121, measurement accuracy is improved.

To obtain effective light energy with respect to the light receiving sensitivity of the image sensor 121 while prioritizing a measurement speed, the optical magnification $\beta_1$ of the light-receiving optical system 122 is preferably made closer to 0 within a range of less than 1. As an example, when $\theta_1 = 70°$, $\beta_1 = 0.05$, and the pixel size of the image sensor 121 is 10 $\mu$m/pixel, the pixel sensitivity to the surface position variation is 105 $\mu$m/pixel. To the contrary, when $\theta_1 = 85°$, $\beta_1 = 0.2$, and the pixel size of the image sensor 121 is 2.0 $\mu$m/pixel, light energy per pixel increases by 3.9 times. In accordance with equation (3), the incident angle becomes smaller, and thus light receiving sensitivity is improved. When light energy per pixel is improved, the exposure time of the image sensor can be shortened, thereby shortening the measurement time.

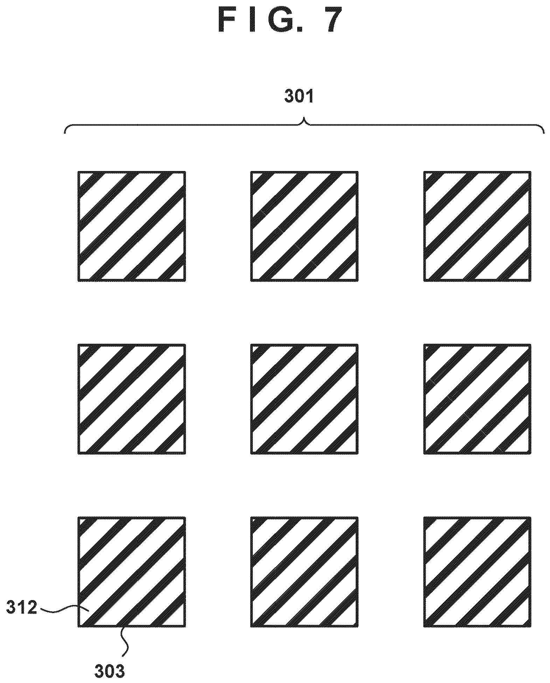

In an example, the projection pattern 112a can include a plurality of patterns. In other words, the plurality of slits of the mask 112 are formed so as to form a plurality of pattern images on the detection surface 300. Fig. 7 shows an example of pattern images 301 of the projection pattern 112a on the detection surface. Each pattern image 301 can include a plurality of partial patterns 312. This can perform surface position detection in a plurality of inspection regions 303 on the detection surface. The mask 112 and the detection surface 300 satisfy the condition of the Scheimpflug optical system, and the detection surface 300 and the image sensor 121 also satisfy the condition of the Scheimpflug optical system. Therefore, the pattern images 301 on the detection surface are formed with constant imaging performance regardless of the positions.

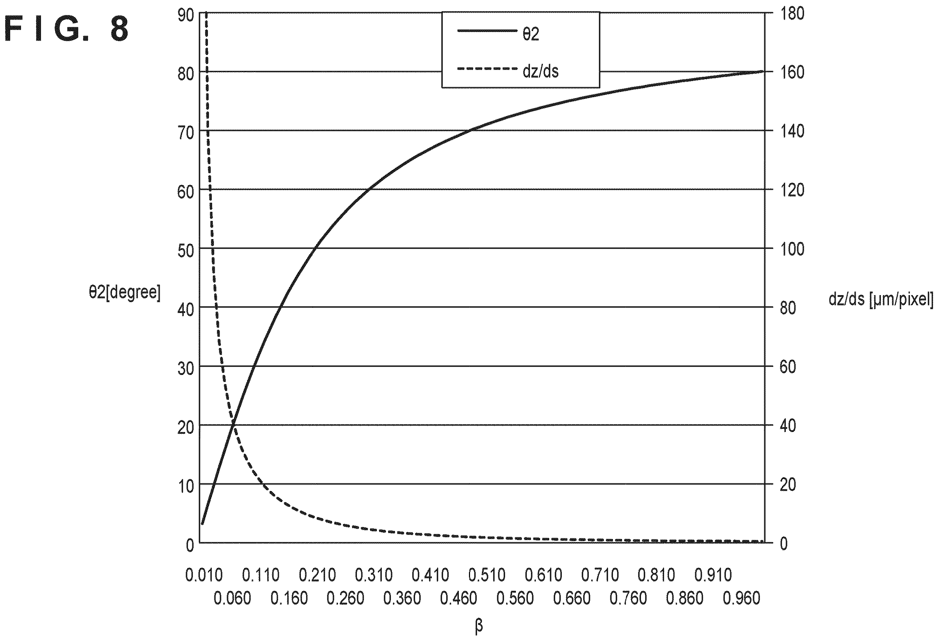

Fig. 8 shows the relationship among the optical magnification $\beta_1$ of the light-receiving optical system 122, the incident angle $\theta_2$ to the image sensor 121, and the pixel sensitivity dz/ds of the image sensor 121 to the surface position variation of the detection surface 300. At this time, assume that $\theta_1 = 80°$ and the pixel size is 5.5 $\mu$m/pixel. The incident angle to the image sensor 121 is decided from equation (3), and the pixel sensitivity of the image sensor 121 to the surface position variation of the detection surface 300 is decided from equation (4). Considering that the incident angle at which the effective light receiving sensitivity of the image sensor 121 is obtained is smaller than 65°, the upper limit of the settable optical magnification $\beta_1$ is decided based on the incident angle to the image sensor 121, and $\beta_1 < 0.40$ is obtained for the case shown in Fig. 8. Furthermore, the pixel sensitivity of the image sensor 121 to the surface position variation of the detection surface 300 is 100 $\mu$m/pixel or less. The lower limit of the settable optical magnification is decided based on 100 $\mu$m/pixel as the upper limit of the pixel sensitivity to the surface position variation, and $\beta_1 > 0.03$ is obtained for the case shown in Fig. 8. Therefore, in a case where $\theta_1 = 80°$ and the pixel size is 5.5 $\mu$m/pixel, the optical magnification is set within a range of $0.03 < \beta_1 < 0.40$.

In summary, when $\theta_1$ represents the incident angle, to the detection surface 300, of light irradiated by the projection optical system 113, $\theta_2$ represents the incident angle, to the image sensor 121, of light irradiated by the light-receiving optical system 122, and $\beta_1$ represents the optical magnification of the light-receiving optical system 122, it is preferable to satisfy:

$$70° < \theta_1 < 85°,$$

$$\theta_2 < 70°,$$

and

$$0.03 < \beta_1 < 0.40$$

In the configuration shown in Fig. 4, when $\theta_3$ represents the angle formed by the optical axis of the projection optical system 113 and the normal to the surface of the mask 112 and $\beta_2$ represents the optical magnification of the projection optical system, it is preferable to satisfy:

$$\beta_2 = \tan\theta_1/\tan\theta_3$$

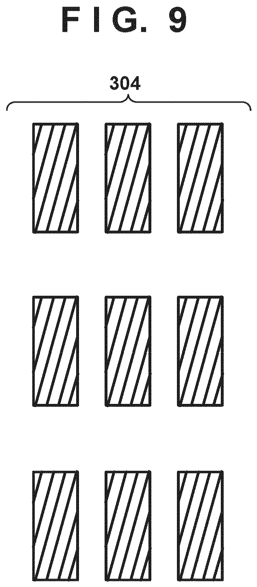

Fig. 9 shows an example of pattern images 304 on the image sensor 121. Since an image is formed on an image plane satisfying the condition of the Scheimpflug optical system, the aspect ratio is different from that of the pattern image 301 (Fig. 7) on the detection surface. The image sensor 121 may be an area sensor including two-dimensional pixels. Since surface position detection of the entire surface on the plurality of inspection regions 303 on the detection surface can be performed using the area sensor, it is possible to perform more accurate surface position detection.

<Second Embodiment>

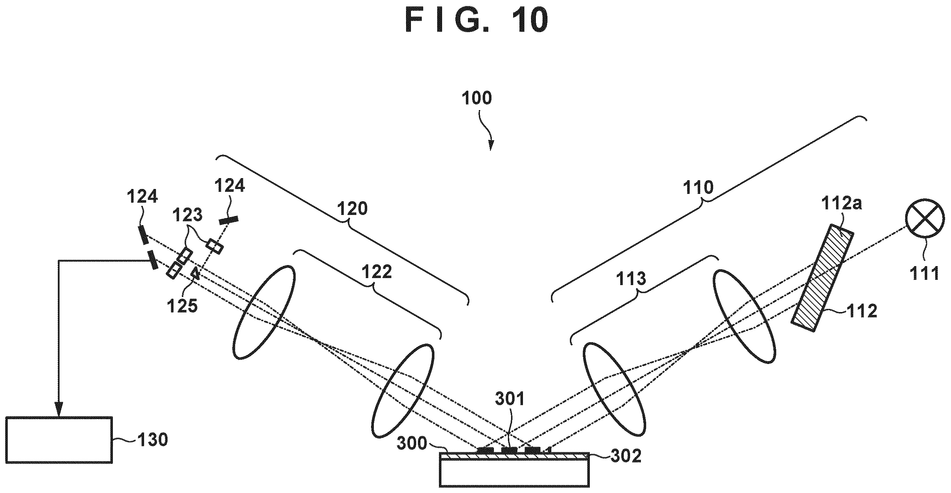

The configuration of a surface position detection apparatus 100 according to the second embodiment will be described with reference to Fig. 10. Referring to Fig. 10, an image sensor 121 includes a line sensor 124 that includes pixels only in one direction. The line sensor is faster than the area sensor from the viewpoint of the number of pixels, and is superior in terms of a measurement speed. In general, the line sensor is less expensive than the area sensor, and is superior in terms of the apparatus cost.

A cylindrical lens 123 may be used for a light-receiving optical system 122. When the cylindrical lens 123 is used to condense light, an amount of light per pixel is improved. By using the cylindrical lens 123, it is possible to compensate for light energy reduced when causing a light beam to enter obliquely with respect to a normal to an image sensor, thereby obtaining a necessary amount of light.

By providing a plurality of line sensors 124, it is possible to perform surface position detection at a plurality of measurement positions on a detection surface 300. A beam splitter 125 may be used for the light-receiving optical system 122. By using the beam splitter 125, it is possible to increase the number of line sensors 124, thereby performing more detailed surface position detection of the detection surface 300.

<Third Embodiment>

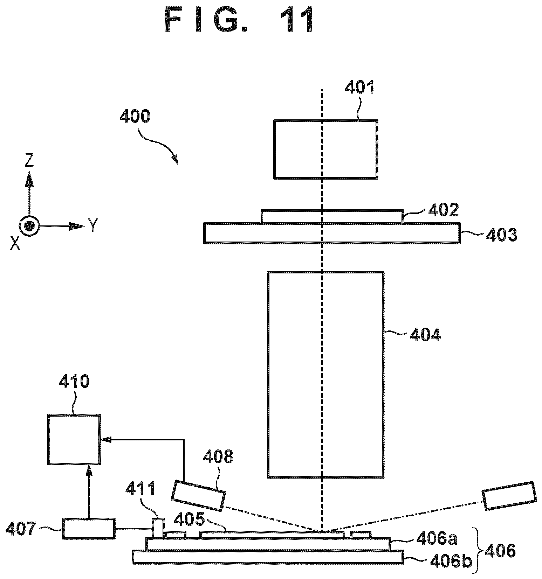

A lithography apparatus including the above-described surface position detection apparatus will be described with reference to Fig. 11. Fig. 11 is a view showing the configuration of an exposure apparatus 400 as an example of the lithography apparatus. The exposure apparatus 400 can include, for example, an illumination optical system 401, an original stage 403 that holds an original 402, a projection optical system 404, a substrate stage 406 that holds a substrate 405, a position measurement unit 407, a focus detector 408, and a controller 410. The controller 410 is formed by, for example, a computer including a CPU and a memory, and controls processing of transferring a pattern of the original 402 to the substrate 405 (processing of exposing the substrate 405).

The exposure apparatus 400 can be an exposure apparatus (stepper) that fixes the original 402 (that is, by a step-and-repeat method) and projects the pattern of the original 402 to the substrate 405. Alternatively, the exposure apparatus 400 can be a scanning exposure apparatus (scanner) that transfers the pattern of the original 402 to the substrate 405 while synchronously scanning the original 402 and the substrate 405 in the scanning direction (that is, by a step-and-scan method).

The illumination optical system 401 uniformly illuminates the original 402 held by the original stage 403 with light emitted from a light source (not shown). Examples of the exposure light are the g-ray and i-ray of ultra-high pressure mercury lamps, a KrF excimer laser, an ArF excimer laser, and an F2 laser. To manufacture a smaller semiconductor device, Extreme UltraViolet light (EUV light) of several nm to several hundred nm may be used as the exposure light.

The projection optical system 404 has a predetermined projection magnification, and projects the pattern of the original 402 to the substrate 405. The substrate stage 406 can include, for example, a substrate chuck 406a that holds the substrate 405, and a substrate driver 406b that drives the substrate chuck 406a (substrate 405). The substrate driver 406b is configured to move the substrate chuck 406a (substrate 405) at least in a direction (X and Y directions) orthogonal to the optical axis of the projection optical system 404. The position measurement unit 407 includes, for example, a laser interferometer, and measures the position of the substrate stage 406. The laser interferometer irradiates a reflector 411 provided on the substrate stage 406 with a laser beam, and detects the displacement of the substrate stage 406 using the laser beam reflected by the reflector 411. Thus, the position measurement unit 407 can obtain the current position of the substrate stage 406 based on the displacement detected by the laser interferometer.

The number of substrate stages is not limited to one. The exposure apparatus 400 may be, for example, a twin-stage type exposure apparatus including two substrate stages 406. With the twin-stage type exposure apparatus, for example, while performing exposure processing for a substrate on one substrate stage, it is possible to perform premeasurement for another substrate on the other substrate stage.

The focus detector 408 can include the configuration of the surface position detection apparatus 100 according to the above-described embodiment. By setting, as a precision inspection region, a region to which the pattern of the original 402 is transferred, it is possible to perform measurement with high accuracy and high throughput.

The controller 410 can control the position of the substrate stage 406 based on the detection result of the surface position detection apparatus (focus detector 408). While exposing the substrate 405, the controller 410 can perform focus control so that the surface of the substrate 405 is arranged on the imaging plane (focus plane) of the projection optical system 404 in accordance with the position (the position of a shot region) on the substrate to be exposed. Focus control can be performed by, for example, driving an optical element (lens) provided in the projection optical system 404 or driving the substrate stage 406 in a direction parallel to the optical axis of the projection optical system 404.

<Embodiment of Article Manufacturing Method>

An article manufacturing method according to the embodiment is suitable for manufacturing an article, for example, a microdevice such as a semiconductor device or an element having a fine structure. The article manufacturing method according to the embodiment includes a forming step of forming the pattern of an original on a substrate using the above-described lithography apparatus (an exposure apparatus, an imprint apparatus, or the like), and a processing step of processing the substrate on which the pattern has been formed in the above step. In addition, the manufacturing method includes other well-known steps (oxidation, film formation, deposition, doping, planarization, etching, resist removal, dicing, bonding, packaging, and the like). The article manufacturing method according to this embodiment is more advantageous than the conventional methods in at least one of the performance, quality, productivity, and production cost of the article.

According to the above-described various embodiments, it is possible to provide a technique advantageous in balancing surface position detection accuracy and cost.

While the present disclosure has been described with reference to embodiments, it is to be understood that the present disclosure is not limited to the disclosed embodiments. The scope of the following claims is to be accorded the broadest interpretation so as to encompass all such modifications and equivalent structures and functions.

Various embodiments have been described in detail above but it will be understood that the present disclosure is not limited to these embodiments and encompasses all modifications, variants, alternatives and equivalents falling within the scope of the appended claims.

**Claims**

1. A detection apparatus (100) for detecting a surface position of a detection surface (300), **characterized by** comprising:

   a mask (112) with a plurality of slits formed;
   a projection optical system (113) configured to form an image on the detection surface by irradiating, from an oblique direction, the detection surface with light having passed through the plurality of slits;
   an image sensor (121); and
   a light-receiving optical system (122) configured to form, on the image sensor, an image of light reflected from the detection surface,
   wherein

$$\beta_1 = \tan\theta_2/\tan\theta_1,$$

$$70° < \theta_1 < 85°,$$

$$\theta_2 < 70°,$$

   and

$$0.03 < \beta_1 < 0.40$$

   are satisfied,
   where $\theta_1$ represents an incident angle, to the detection surface, of the light irradiated by the projection optical

system, $\theta_2$ represents an incident angle, to the image sensor, of the light irradiated by the light-receiving optical system, and $\beta_1$ represents an optical magnification of the light-receiving optical system.

2. The apparatus according to claim 1, **characterized in that**

$$\beta_2 = \tan\theta_1/\tan\theta_3$$

is satisfied,
where $\theta_3$ represents an angle formed by an optical axis of the projection optical system and a normal to a surface of the mask and $\beta_2$ represents an optical magnification of the projection optical system.

3. The apparatus according to claim 1, **characterized in that**
in a state in which $\beta_1 = \tan\theta_2/\tan\theta_1$ is satisfied, the mask and the detection surface have a relationship satisfying a Scheimpflug condition with respect to the projection optical system.

4. The apparatus according to claim 2, **characterized in that**
in a state in which $\beta_2 = \tan\theta_1/\tan\theta_3$ is satisfied, the detection surface and the image sensor have a relationship satisfying a Scheimpflug condition with respect to the light-receiving optical system.

5. The apparatus according to any one of claims 1 to 4, **characterized in that**
pixel sensitivity of the image sensor to a surface position variation of the detection surface is not less than 0.1 $\mu$m/pixel.

6. The apparatus according to any one of claims 1 to 5, **characterized in that**
pixel sensitivity of the image sensor to a surface position variation of the detection surface is not more than 100 $\mu$m/pixel.

7. The apparatus according to any one of claims 1 to 6, **characterized in that**
the plurality of slits of the mask are formed so as to form a plurality of pattern images on the detection surface.

8. A lithography apparatus for forming a pattern on a substrate using an original, **characterized by** comprising:

   a stage configured to hold the substrate;
   a detection apparatus defined in any one of claims 1 to 7 and configured to detect a surface position of the substrate held by the stage; and
   a controller configured to control a position of the stage based on a detection result of the detection apparatus.

9. An article manufacturing method **characterized by** comprising:

   forming a pattern on a substrate using a lithography apparatus defined in claim 8;
   processing the substrate on which the pattern has been formed in the forming; and
   manufacturing an article from the substrate processed in the processing.

# FIG. 1

# FIG. 2

# FIG. 3

# FIG. 4

# FIG. 5

# FIG. 6

RELATIVE
INTENSITY
[a.u.]

ANGLE [deg]

# F I G. 7

FIG. 8

# F I G. 9

304

# F I G. 10

# F I G. 11

Europäisches
Patentamt

European
Patent Office

Office européen
des brevets

# EUROPEAN SEARCH REPORT

**Application Number**

EP 25 20 4562

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | JP H10 4054 A (CANON KK) 6 January 1998 (1998-01-06) * paragraphs [0029], [0031]; figures 1,8 * | 1-9 | INV. G03F9/00 |
| A | US 11 099 007 B2 (NIKON CORP [JP]) 24 August 2021 (2021-08-24) * column 11, line 1 - column 12, line 18; figures 12A, 12B * | 1-9 | |
| A | US 2008/151258 A1 (CANON KK [JP]) 26 June 2008 (2008-06-26) * paragraph [0062]; figure 1 * | 1-9 | |
| A | EP 2 546 599 A1 (GOEPEL ELECTRONIC GMBH [DE]) 16 January 2013 (2013-01-16) * figure 2 * | 1-9 | |

**TECHNICAL FIELDS SEARCHED (IPC)**

G03F

The present search report has been drawn up for all claims

| Place of search | Date of completion of the search | Examiner |
|---|---|---|
| The Hague | 30 March 2026 | Peters, Volker |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 4562

This annex lists the patent family members relating to the patent documents cited in the above-mentioned European search report.
The members are as contained in the European Patent Office EDP file on
The European Patent Office is in no way liable for these particulars which are merely given for the purpose of information.

30-03-2026

| Patent document cited in search report | | Publication date | Patent family member(s) | Publication date |
|---|---|---|---|---|
| JP H104054 | A | 06-01-1998 | NONE | |
| US 11099007 | B2 | 24-08-2021 | NONE | |
| US 2008151258 | A1 | 26-06-2008 | NONE | |
| EP 2546599 | A1 | 16-01-2013 | DE 102011051781 A1 | 17-01-2013 |
| | | | EP 2546599 A1 | 16-01-2013 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3204406 B
- JP 10004054 A

- JP 3271720 B